(19) **Europäisches Patentamt / European Patent Office / Office européen des brevets**

(11) **EP 4 571 688 A1**

(12) **EUROPEAN PATENT APPLICATION**
published in accordance with Art. 153(4) EPC

(43) Date of publication:
18.06.2025 Bulletin 2025/25

(21) Application number: 23853099.2

(22) Date of filing: 11.08.2023

(51) International Patent Classification (IPC):
*G07C 5/02* (2006.01)    *G01R 31/00* (2006.01)
*G01R 22/06* (2006.01)    *G07C 5/00* (2006.01)
*B60L 3/12* (2006.01)

(52) Cooperative Patent Classification (CPC):
B60L 3/12; G01R 22/06; G01R 31/00; G07C 5/00;
G07C 5/02

(86) International application number:
PCT/KR2023/012004

(87) International publication number:
WO 2024/035234 (15.02.2024 Gazette 2024/07)

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: 12.08.2022  KR 20220101645

(71) Applicant: **LG Energy Solution, Ltd.**
**Seoul 07335 (KR)**

(72) Inventors:
• **KIM, Kang San**
  **Daejeon 34122 (KR)**
• **CHOI, Yo Hwan**
  **Daejeon 34122 (KR)**
• **OH, Hyun Seok**
  **Daejeon 34122 (KR)**

(74) Representative: **Goddar, Heinz J.**
**Boehmert & Boehmert**
**Anwaltspartnerschaft mbB**
**Pettenkoferstrasse 22**
**80336 München (DE)**

(54) **FUEL EFFICIENCY ANALYSIS DEVICE, SYSTEM INCLUDING SAME, AND OPERATION METHOD THEREOF**

(57)    An electricity efficiency analysis device according to various embodiments includes an output device and a processor electrically connected to the output device, the processor configured to calculate an electricity efficiency gain-loss value indicating a gain or loss of current electricity efficiency compared to a standard electricity efficiency of a vehicle based on information collected during a predetermined monitoring section related to state and driving of the vehicle, calculate a standard electricity efficiency contribution indicating an extent to which the state and driving of the vehicle during the predetermined monitoring section have influenced the gain or loss of the current electricity efficiency compared to the standard electricity efficiency based on a power consumption rate and the electricity efficiency gain-loss value during the predetermined monitoring section, and output the standard electricity efficiency contribution through the output device.

FIG. 1B

**Description**

**[TECHNICAL FIELD]**

CROSS-REFERENCE TO RELATED APPLICATION

The embodiments disclosed in this document claim the benefit of priority based on Korean Patent Application Nos. 10-2022-0101645 filed on August 12, 2022, and 10-2023-0105701 filed on August 11, 2023, and the entirety of the contents disclosed in those Korean patent applications is included as a part of this specification.

TECHNICAL FIELD

The various embodiments disclosed in this document relate to an electricity efficiency analysis device, system including the same, and operating method thereof, and more particularly, to a technology for analyzing factors influencing the electricity efficiency of a vehicle.

**[BACKGROUND ART]**

Due to growing environmental concerns, there is an increase in the adoption of eco-friendly vehicles, such as electric cars and fuel cell vehicles. These eco-friendly vehicles are equipped with batteries and run on the battery's electric energy.
The vehicle provides a function to calculate and display the vehicle's electricity efficiency (or driving electricity efficiency) through instruments such as the cluster. Electricity efficiency can be calculated as the distance that can be traveled per 1 kWh of electrical energy.
Typically, electricity efficiency can be derived based on the consumption of electrical energy and the distance traveled over a specific distance section. For example, electricity efficiency can be calculated as the ratio of electrical energy consumption to the distance traveled.
The provision of this electricity efficiency can help drivers plan their charging during or before driving. However, even among vehicles of the same type, electricity efficiency can vary depending on road conditions, driver's driving habits, and vehicle condition, and drivers cannot discern from the provided electricity efficiency alone which factors affect the electricity efficiency.

**[DISCLOSURE]**

**[TECHNICAL PROBLEM]**

At least one of the various embodiments of the present invention aims to provide an electricity analysis device, a system including the same, and operating method thereof designed to analyze factors influencing the electricity efficiency of a vehicle.
At least one of the various embodiments of the present invention aims to provide an electricity efficiency analysis device, system including the same, and opera ting method thereof designed to analyze the reasons for an increase or decrease in the current electricity efficiency of a vehicle compared to the standard electricity efficiency.

**[TECHNICAL SOLUTION]**

An electricity efficiency analysis device according to various embodiments includes an output device and a processor electrically connected to the output device, the processor configured to calculate an electricity efficiency gain-loss value indicating a gain or loss of current electricity efficiency compared to a standard electricity efficiency of a vehicle based on the information collected during a predetermined monitoring section related to the state and driving of the vehicle, calculate a standard electricity efficiency contribution indicating an extent to which the state and driving of the vehicle during the predetermined monitoring section have influenced the gain or loss of the current electricity efficiency compared to the standard electricity efficiency based on a power consumption rate and the electricity efficiency gain-loss value during the predetermined monitoring section, and output the standard electricity efficiency contribution through the output device.
According to various embodiments, the processor may be configured to calculate the power consumption rate as a ratio of power consumed during the predetermined monitoring section to a total power consumption.
According to various embodiments, the processor may be configured to calculate the standard electricity efficiency contribution using a product of the power consumption rate and the electricity efficiency gain-loss value.
According to various embodiments, the processor may be configured to divide the predetermined monitoring section into a plurality of speed sections satisfying predetermined speed conditions based on the information and calculate speed section-specific standard electricity efficiency contributions.

According to various embodiments, the processor may be configured to divide each speed section into a plurality of speed variation sections satisfying predetermined speed variation conditions and calculate speed variation section-specific standard electricity efficiency contributions.

According to various embodiments, the processor may be configured to output at least one of a first standard electricity efficiency contribution related to a recent driving of the vehicle or a second standard electricity efficiency contribution related to a past driving history of the vehicle.

According to various embodiments, the processor may be configured to calculate a gain-loss cost incurred based on the standard electricity efficiency contribution and output information on the gain-loss cost through the output device.

According to various embodiments, the electricity efficiency analysis device may further include a communication circuitry configured to establishing communication with a vehicle diagnostic device, wherein the processor may be configured to acquire the information related to the state and driving of the vehicle through the vehicle diagnostic device.

An electricity efficiency analysis system according to various embodiments includes a vehicle diagnostic device configured to acquire information related to state and driving of a vehicle and an electricity efficiency analysis device capable of communicating with the vehicle antagonistic device, the electricity efficiency analysis device configured to acquire an electricity efficiency gain-loss value indicating a gain or loss of current electricity efficiency of the vehicle compared to a standard electricity efficiency of the vehicle and a power consumption rate of the vehicle during a predetermined monitoring section based on the information acquired by the vehicle diagnostic device, and calculate a standard electricity efficiency contribution indicating an extent to which the state and driving of the vehicle during the predetermined monitoring section have influenced the gain or loss of the current electricity efficiency compared to the standard electricity efficiency, based on the acquired electricity efficiency gain-loss value and power consumption rate.

According to various embodiments, the electricity efficiency analysis device may be configured to acquire the electricity efficiency gain-loss value and the power consumption rate calculated by the vehicle diagnostic device.

According to various embodiments, the electricity efficiency analysis device may be configured to calculate the electricity efficiency gain-loss value and the power consumption rate based on the Information acquired through the vehicle diagnostic device.

According to various embodiments, the electricity efficiency analysis device may be configured to calculate the standard electricity efficiency contribution using a product of the power consumption rate and the electricity efficiency gain-loss value.

An operating method of an electricity efficiency analysis device according to various embodiments may include calculating an electricity efficiency gain-loss value indicating a gain or loss of current electricity efficiency compared to a standard electricity efficiency of a vehicle based on information collected during a predetermined monitoring section related to state and driving of the vehicle, calculating a standard electricity efficiency contribution indicating an extent to which the state and driving of the vehicle during the predetermined monitoring section have influenced the gain or loss of the current electricity efficiency compared to the standard electricity efficiency based on a power consumption rate and the electricity efficiency gain-loss value during the predetermined monitoring section, and outputting the standard electricity efficiency contribution through an output device.

According to various embodiments, the power consumption rate may be calculated as a ratio of power consumed during the predetermined monitoring section to a total power consumption.

According to various embodiments, the standard electricity efficiency contribution may be calculated using a product of the power consumption rate and the electricity efficiency gain-loss value.

According to various embodiments, outputting the standard electricity efficiency contribution may include dividing the predetermined monitoring section into a plurality of speed sections satisfying predetermined speed conditions based on the information and calculating speed section-specific standard electricity efficiency contributions.

According to various embodiments, outputting the standard electricity efficiency contribution may include dividing each speed section into a plurality of speed variation sections satisfying predetermined speed variation conditions and calculating speed variation section-specific standard electricity efficiency contributions.

According to various embodiments, outputting the standard electricity efficiency contribution may include outputting at least one of a first standard electricity efficiency contribution related to a recent driving of the vehicle or a second standard electricity efficiency contribution related to a past driving history of the vehicle.

According to various embodiments, outputting the standard electricity efficiency contribution may include calculating a gain-loss cost incurred based on the standard electricity efficiency contribution and outputting information on the gain-loss cost through the output device.

The operating method of the electricity efficiency analysis device according to various embodiments may further include establishing communication with a vehicle diagnostic device and acquiring the information related to the state and driving of the vehicle through the vehicle diagnostic device.

[ADVANTAGEOUS EFFECTS]

The electricity efficiency analysis device according to various embodiments disclosed in this document can analyze factors influencing the electricity efficiency of a vehicle, enabling drivers to become aware of the factors contributing to forming electricity efficiency.

The electricity efficiency analysis device according to various embodiments disclosed in this document can induce efficient driving habits for improving electricity efficiency by analyzing the extent to which the current electricity efficiency of a vehicle, compared to the standard electricity efficiency, affects the gains or losses (e.g., increase or decrease).

The effects achievable from this document are not limited to those mentioned above.

[DESCRIPTION OF DRAWINGS]

FIG. 1A is a schematic diagram illustrating the configuration of an electricity efficiency analysis system according to various embodiments;

FIG. 1B is a diagram illustrating the configuration of an electricity efficiency analysis device according to various embodiments;

FIGS. 2A and 2B are diagrams illustrating the calculation operation of a standard electricity efficiency contribution according to various embodiments;

FIGS. 3A and 3B are diagrams illustrating the calculated values of standard electricity efficiency contribution according to various embodiments;

FIGS. 4A to 4D are diagrams illustrating the output operations of standard electricity efficiency contribution according to various embodiments;

FIG. 5 is a flowchart illustrating the operation of an electricity efficiency analysis device according to various embodiments; and

FIG. 6 is a flowchart illustrating the operation of calculating power consumption rate and electricity efficiency gain/loss values in an electricity efficiency analysis device according to various embodiments.

[MODE FOR INVENTION]

Hereinafter, some embodiments of the present invention are described in detail with reference to accompanying drawings. It should be noted that the same numerals are assigned to identical components, even though they are shown on different drawings. In addition, in the following description of the embodiments of the present invention, detailed descriptions of well-known components and functions may be omitted if they are deemed to obstruct the understanding of the embodiments of the present invention.

In describing the components of the embodiments of the present invention, terms such as "first," "second," "A," "B," "(a)," "(b)," etc., may be used. These terms are only used only to distinguish one component from another component, and the nature, sequence, or order of the corresponding components are not limited by the term. Furthermore, unless otherwise defined differently, all terms used herein, including technical or scientific terminology, have the same meanings as understood by those skilled in the art in the relevant field of the invention. It will be further understood that terms, such as those defined in commonly used dictionaries, should be interpreted as having a meaning that is consistent with their meaning in the context of the relevant art and should not be interpreted in an idealized or overly formal sense unless expressly so defined herein.

The vehicle referred to in the following description may include a vehicle that is operated under the control of a boarded driver and a self-driving vehicle that can operate on its own without the driver's manipulation. In addition, the following description describes a car as an example of a vehicle, but the invention is not limited thereto. For example, the following embodiments can be applied to various means of transportation, such as ships, aircraft, trains, motorcycles, or bicycles.

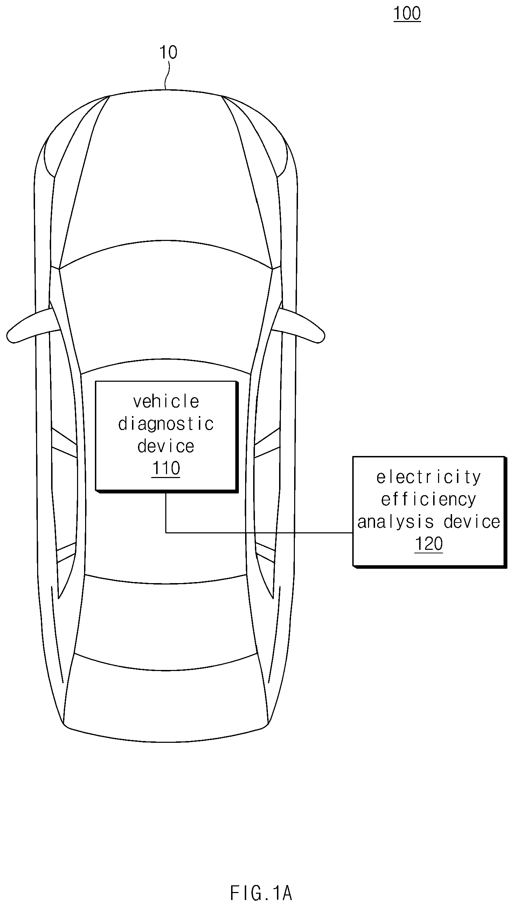

Hereinafter, the embodiments of the present invention are described in detail with reference to FIGS. 1A to 6.

FIG. 1A is a schematic diagram illustrating the configuration of an electricity efficiency analysis system according to various embodiments.

With reference to FIG. 1A, the electricity efficiency analysis system 100 according to various embodiments may include a vehicle diagnostic device 110 and an electricity efficiency analysis device 120.

According to various embodiments, the vehicle diagnostic device 110 may be mounted within the vehicle 10 and may acquire information related to the state or operation of the vehicle 10. Information related to the state of the vehicle 10 may include diagnostic information about the components (e.g., the battery, sensors, motor, accelerator, and decelerator) of the vehicle 10. In addition, information related to the operation of the vehicle may include speed, traveled distance, driving time, location, and electricity consumption of the vehicle 10. In an embodiment, the vehicle diagnostic device 110 may include an on-board diagnostic (OBD) device. Such OBD devices might encompass various devices that output information about the vehicle's condition or driving to the outside (e.g., fuel efficiency analysis device 120), not restricted to OBD-I, OBD 1.5, and OBD-II.

According to various embodiments, the electricity efficiency analysis device 120 may analyze factors influencing the electricity efficiency of the vehicle based on various information obtained through the vehicle diagnostic device 110. The electricity efficiency analysis device 120 may calculate a standard electricity efficiency contribution, which indicates the extent to which the current electricity efficiency of the vehicle 10 affects the gains or losses (e.g. increase or decrease) within a driving section (or a section where the electrical energy of the vehicle 10 is consumed) compared to the standard electricity efficiency (e.g., certified electricity efficiency). The standard electricity efficiency may be measured under specified conditions by the vehicle diagnostic device 110, the electricity efficiency analysis device 120, or a designated certification authority. For example, the electricity efficiency analysis device 120 may include a portable communication device such as a smart phone, a computer device, a portable multimedia device, a wearable device, or a server such as a cloud server, and various embodiments are not limited to the examples.

Hereinafter, a description is made of the calculation of the standard electricity efficiency contribution by the electricity efficiency analysis device 120 in detail with reference to accompanying drawings.

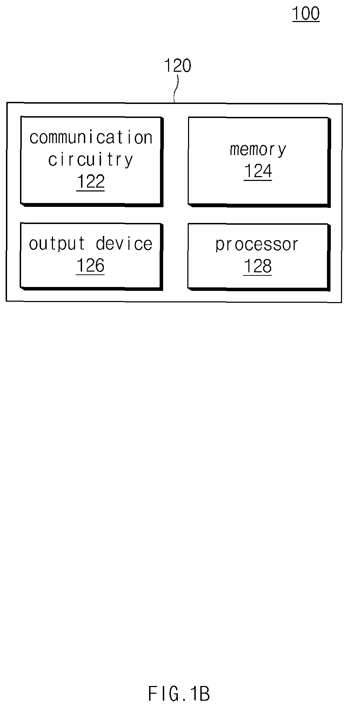

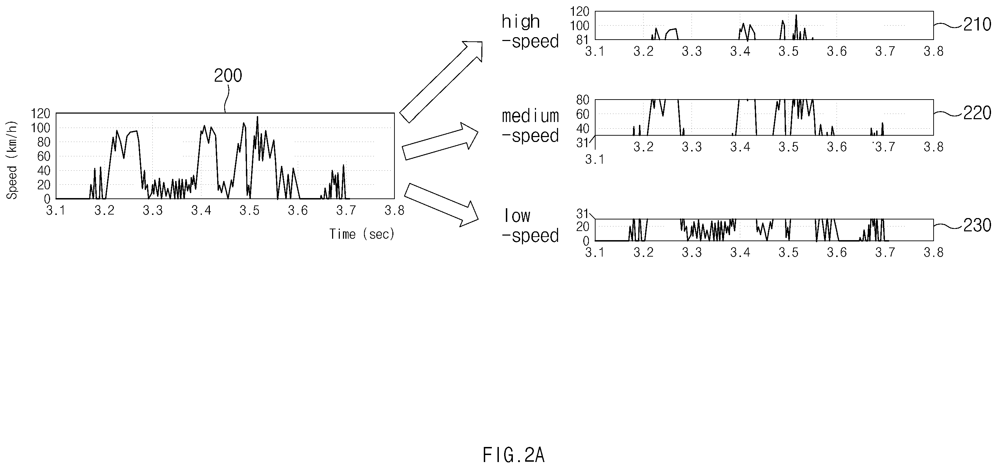

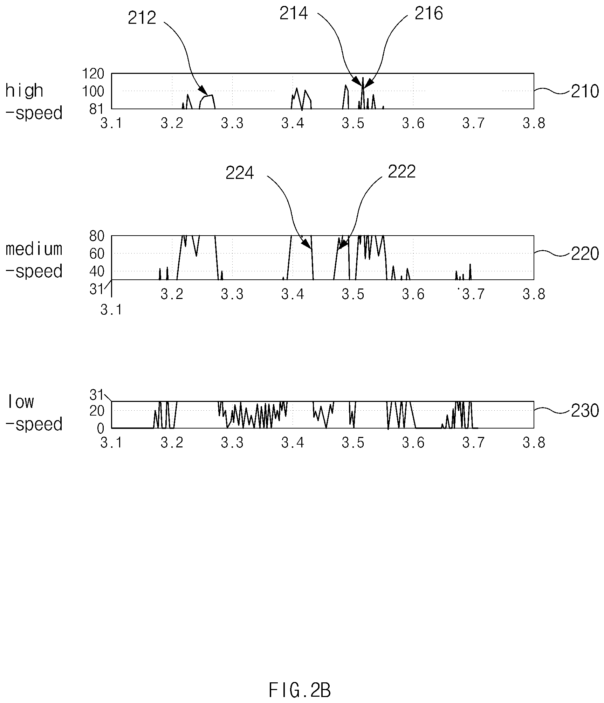

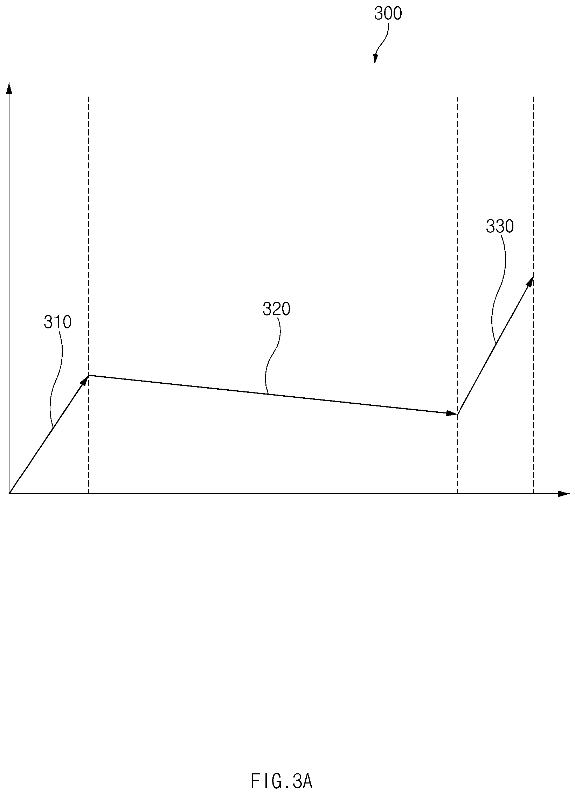

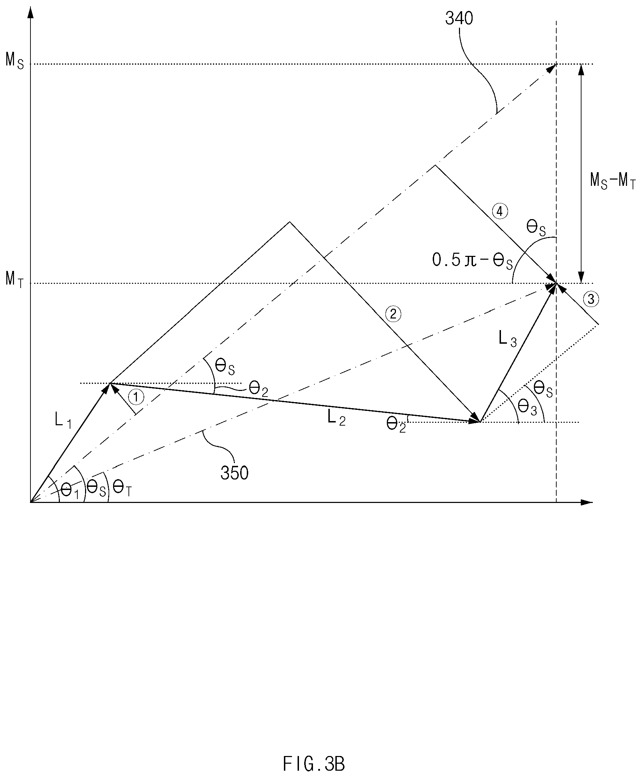

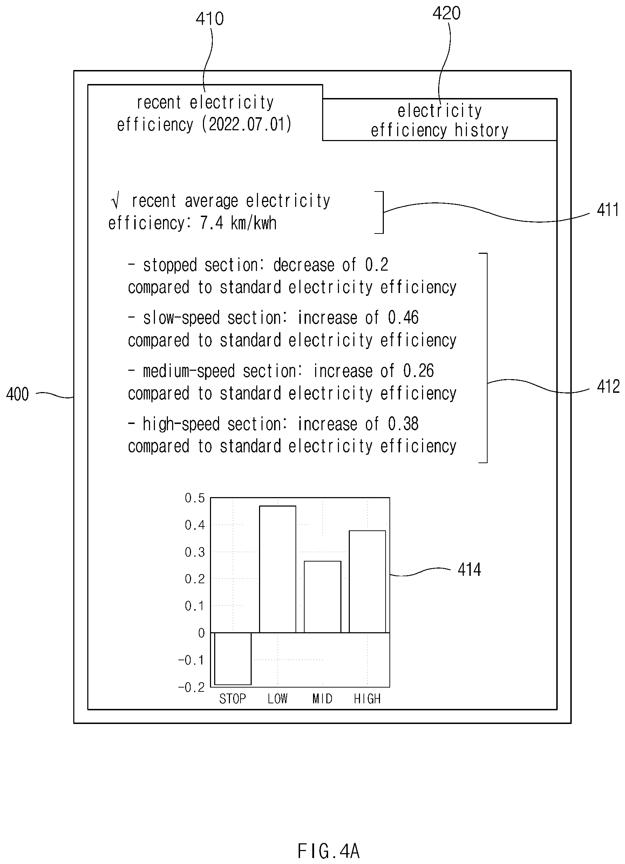

FIG. 1B is a diagram illustrating the configuration of an electricity efficiency analysis device according to various embodiments. And FIGS. 2A and 2B are diagrams illustrating the calculation operation of a standard electricity efficiency contribution according to various embodiments, FIGS. 3A and 3B are diagrams illustrating the calculated values of standard electricity efficiency contribution according to various embodiments, and lastly, FIGS. 4A to 4D are diagrams illustrating the output operations of standard electricity efficiency contribution according to various embodiments.

With reference to FIG. 1B, the electricity efficiency analysis device 120 may include communication circuitry 122, a memory 124, an output device 126, and a processor 128. However, this is exemplary, and various embodiments are not limited thereto. For example, at least one of the components of the electricity efficiency analysis device 120 may be omitted, or one or more other components (e.g., an input device, at least one sensor, a power management device, etc.) may be added to the configuration of the electricity efficiency analysis device 120. In addition, at least one of the components may be integrated with other components.

According to various embodiments, the communication circuitry 122 may establish a wired or wireless communication channel between the electricity efficiency analysis device 120 and the vehicle diagnostic device 110 and support communication operations through the established communication channels. In addition, the communication circuitry 122 may also establish communication with other external devices (e.g., servers) aside from the vehicle diagnostic device 110.

For example, the communication circuitry 122 may include a wireless communication circuit (e.g., a cellular communication circuit or short-range wireless communication circuit) or a wired communication circuit (e.g., a local area network or power line communication circuit).

According to various embodiments, the memory 124 may contain programs, algorithms, routines, and/or instructions related to the operation (or control) of the electricity efficiency analysis device 120.

For example, the memory 124 may encompass memory types like flash memory type, hard disk type, micro type, and card type (e.g., secure digital (SD) card or eXtream (XD) digital card), as well as at least one type of storage medium among random access memory (RAM), static RAM (SRAM), read-only memory (ROM), programmable ROM (PROM), electrically erasable PROM (EEPROM), magnetic RAM (MRAM), magnetic disk, and optical disk types, however, various embodiments are not limited to these examples.

According to various embodiments, the output device 126 may provide information related to the operation of the electricity efficiency analysis device 120. In an embodiment, the output device 126 may include a display configured to output visual information. For example, the display may include one or more of a liquid crystal display, a thin film transistor-liquid crystal display, an organic light-emitting diode, a flexible display, a 3-dimensional (3D) display, and a transparent display. The display 120 may also include a touch sensor configured to detect touches.

However, this is exemplary, and various embodiments are not limited thereto. For example, information related to the operation of the electricity efficiency analysis device 120 may be provided in the form of auditory information. In this case, the output device 126 may further include a sound output device (e.g., speakers) configured to output audio signals from the electricity efficiency analysis device 120 to the outside.

According to various embodiments, the processor 128 may control at least one other component of the electricity efficiency analysis device 120 (e.g., communication circuitry 122, memory 124, and output device 126) and perform various data processing or computations.

According to an embodiment, the processor 128 may provide electricity efficiency (or driving electricity efficiency) for the vehicle 10 based on various information obtained through the vehicle diagnostic device 110. Electricity efficiency may be calculated as the distance that can be traveled per 1 kWh of electrical energy.

For example, the processor 128 may obtain information about the driving distance and the consumption of electrical energy in a certain section through the vehicle diagnostic device 110. In relation to this, the processor 128 may calculate electricity efficiency by using the ratio of electrical energy consumption to the distance traveled.

The provision of this electricity efficiency can help drivers plan their charging during or before driving. However, even among vehicles of the same type, electricity efficiency can vary depending on road conditions, driver's driving habits, and vehicle condition, and drivers cannot discern from the provided electricity efficiency alone which factors affect the electricity efficiency.

In this regard, the processor 128 may analyze factors influencing the electricity efficiency of the vehicle 10 based on various information obtained through the vehicle diagnostic device 110, as described below. For example, the processor 128 may calculate the standard electricity efficiency contribution, indicating the extent to which the current electricity efficiency of the vehicle 10, compared to the standard electricity efficiency (e.g., certified electricity efficiency), affects the gains or losses (e.g., increase or decrease).

According to an embodiment, the processor 128 may divide (or split) the section in which the electric energy of the vehicle 10 is consumed into a plurality of sections and calculate the standard electricity efficiency contribution for each section.

According to an embodiment, the processor 128 may divide the monitoring section in which the electric energy consumed by the vehicle 10 in driving is monitored into multiple sections and calculate the standard electricity efficiency contribution for each section. In this case, the processor 128 may divide the monitoring section into a plurality of speed sections.

For example, as shown in FIG. 2A, the processor 128 may divide the monitoring section 200, based on the speed of the vehicle 10, into a first section 210 corresponding to the first speed range (e.g., 81 km/h or above), a second section 220 corresponding to the second speed range (e.g., 31 km/h to 80 km/h), and a third section 230 corresponding to the third speed range (e.g., 1 km/h to 30 km/h).

Subsequently, the processor 128 may calculate the first standard electricity efficiency contribution, the second standard electricity efficiency contribution, and the third standard electricity efficiency contribution for each of the first section 210, second section 220, and third section 230, respectively.

According to an embodiment, the processor 128 may use Equation 1 below to calculate the standard electricity efficiency contribution.

$$\text{Standard electricity efficiency contribution} = \text{power consumption rate} * \text{Electricity efficiency gain-loss value} \qquad \text{[Equation 1]}$$

Power consumption rate = $\dfrac{E_i}{E_T}$ , Electricity efficiency gain-loss value = $\dfrac{M_i}{E_i} - \dfrac{M_S}{E_T}$

In Equation 1, the power consumption rate ( $\dfrac{E_i}{E_T}$ ) may represent the proportion of power ($E_i$) consumed in the corresponding section relative to the total power consumption ($E_T$), and the electricity efficiency gain-loss value ( $\dfrac{M_i}{E_i} - \dfrac{M_S}{E_T}$ ) may represent the gains or losses of the current electricity efficiency ( $\dfrac{M_i}{E_i}$ ) compared to the standard electricity efficiency ( $\dfrac{M_S}{E_T}$ ) of the vehicle that is calculated based on the standard electricity efficiency ( $\dfrac{M_S}{E_T}$ ) of the vehicle and the power ($E_i$) consumed in the corresponding section to the driving distance ($M_i$). Here, $M_S$ may represent the total achievable driving distance based on the standard electricity efficiency. For example, the electricity efficiency gain or loss value may be expressed as either a positive or negative value. In addition, sections with positive values indicate sections where the electricity efficiency is higher than the standard electricity efficiency, while sections with negative values indicate sections where the electricity efficiency is lower than the standard electricity efficiency.

Equation 1 may be explained through FIGS. 3A and 3B and Equations 2 and 3 below.

As shown in FIGS. 3A and 3B, within the overall monitoring section 300 encompassing the first section 310, second section 320, and third section 330, the difference (④) between the standard electricity efficiency of the vehicle 340) and the current electricity efficiency of the vehicle 350 may be expressed as the sum of the first standard electricity efficiency contribution (①) for the first section 310, the second standard electricity efficiency contribution (②) for the second section 320, and the third standard electricity efficiency contribution (③) for the third section 330.

This difference in electricity efficiency (④) may be derived using Equation 2.

[Equation 2]

$$\frac{M_S - M_T}{E_T} = \frac{④}{E_T \times \cos(\theta_S)} = \frac{① + ② + ③}{E_T \times \cos(\theta_S)}$$

$$= \frac{1}{E_T \times \cos(\theta_S)} (L_1 \times \sin(\theta_i - \theta_S) + L_2 \times \sin(\theta_i - \theta_S) + L_2 \times \sin(\theta_i - \theta_S))$$

Based on Equation 2 above, the standard electricity efficiency contribution may be derived using Equation 3.

[Equation 3]

$$i\ \text{section standard contribution electricity efficiency} \ \frac{km}{kwh} = \frac{(L_i \times \sin(\theta_i - \theta_S))}{E_T \times \cos(\theta_S)} = \frac{(E_i \times \sin(\theta_i - \theta_S))}{E_T \times \cos(\theta_S) \times \cos(\theta_S)}$$

$$= \frac{(E_i \times (\sin(\theta_i)\cos(\theta_S) - \cos(\theta_i)\sin(\theta_S)))}{E_T \times \cos(\theta_S) \times \cos(\theta_i)} = \frac{E_i}{E_T} \left( \frac{M_i}{E_i} - \frac{M_S}{E_T} \right)$$

According to an embodiment, examples of standard electricity efficiency contribution calculated based on Equation 1 may be summarized as in Table 1 below.

Table 1

|  | First section | Second section | Third section |
|---|---|---|---|
| Driving distance | 6 km | 12 km | 8 km |
| Section consumption energy | 3 kwh | 3 kwh | 4 kwh |
| Standard electricity efficiency | 3 km/kwh | | |
| Electricity efficiency (section electricity efficiency) | 2 km/kwh | 4 km/kwh | 2 km/kwh |
| Entire section electricity efficiency | 2.6 km/kwh | | |
| Power consumption rate | 0.3 | 0.3 | 0.4 |
| Electricity efficiency gain-loss value | -1 | +1 | -1 |
| Standard electricity efficiency contribution | -0.3 | +0.3 | -0.4 |

Referring to Table 1, it is observed that the sum of the standard electricity efficiency and the standard electricity efficiency contributions of individual sections (e.g., 3 - 0.3 + 0.3 - 0.4 = 2.6) is equal to the efficiency (e.g., 26 km/10 kWh = 2.6) of the entire section (e.g., from section 1 to section 3). Furthermore, it is observed that the efficiency of the first section (e.g., 2 km/kWh) and the efficiency of the third section (e.g., 2 km/kWh) are the same, but the standard electricity efficiency contribution of the first section (e.g., -0.3) and the standard electricity efficiency of the third section (e.g., -0.4) are different from each other. This means that the standard electricity efficiency contribution in the same electricity efficiency section may vary depending on the driver's driving behavior. In this regard, the processor 128 may accurately analyze the factors influencing the efficiency through the standard electricity efficiency contribution and provide them to the driver. As described above, the electricity efficiency analysis device 120 may calculate the power consumption rate and the electricity efficiency gain-loss value based on various information obtained through the vehicle diagnostic device 110. However, this is exemplary, and various embodiments are not limited thereto. For example, at least some of the power consumption rate and the electricity efficiency gain-loss value may be calculated by the vehicle diagnostic device 110 or other external devices and provided to the electricity efficiency analysis device 120. According to an embodiment, the processor 128 may divide the monitoring section into a plurality of speed sections and further subdivide each speed section into a plurality of sections to calculate the standard efficiency contribution. In this case, the processor 128 may further divide each speed section into a plurality of speed variation sections. The speed variation section may encompass at least one of an acceleration section (e.g., a section with acceleration less than 10 km/h per second), a rapid acceleration section (e.g., a section with acceleration greater than or equal to 10 km/h per second), a deceleration section (e.g., a section with deceleration less than 10 km/h per second), a rapid deceleration section (e.g., a section with deceleration greater than or equal to 10 km/h per second), or a constant speed section (e.g., a section with an average acceleration less than 0.2).

For example, as shown in FIG. 2B, the processor 128 may divide the first section 210 of the monitoring section 200 into speed variation sections such as a constant speed section 212, a rapid acceleration section 214, and a rapid deceleration section 216, and similarly, the second section 220 of the monitoring section 200 into speed variation sections such as an acceleration section 222 and a deceleration section 224. In addition, the processor 128 may differentiate only certain sections satisfying a predetermined condition among the constant speed section 212, rapid acceleration section 214, and rapid deceleration section 216 of the first section 210 of the monitoring section 200 as speed variation sections. Of course, the processor 128 may also differentiate only certain sections satisfying a predetermined condition among the plurality of speed sections within the monitoring section 200 as speed variation sections.

Afterward, the processor 128 may calculate the standard electricity efficiency contribution for each speed section.

As described above, the standard electricity efficiency contribution may be calculated based on the section (e.g., monitoring section) in which electric energy is consumed by the vehicle 10 in driving. However, this is exemplary, and various embodiments are not limited thereto. For example, additionally or alternatively, the processor 128 may also calculate the standard electricity efficiency contribution based on the section where energy is consumed even when actual driving does not occur (e.g., stopped state).

According to an embodiment, the processor 128 may calculate the power consumption rate based on the power consumed in a stopped state. For example, the processor 128 may calculate the standard electricity efficiency contribution for the stopped state based on the power consumption rate calculated based on the power consumed by the air conditioning device (e.g., a cooling device or a heating device) and the electricity efficiency gain-loss value calculated for the stopped state (e.g., with a driving distance of 0 km).

According to various embodiments, the processor 128 may output information related to the calculated standard electricity efficiency contribution (or electricity efficiency contribution information).

According to an embodiment, as shown in FIG. 4A, the processor 128 may output electricity efficiency contribution information 400 including first electricity efficiency contribution information 410 related to recent electricity efficiency (or recent driving) and second electricity efficiency contribution information 420 related to electricity efficiency history (or past driving history). In this case, the processor 128 may selectively output the first electricity efficiency contribution information 410 or the second electricity efficiency contribution information 420 based on user input. Of course, the processor 128 may also output both the first electricity efficiency contribution information 410 and the second electricity efficiency contribution information 420 based on or regardless of user input.

According to an embodiment, the first electricity efficiency contribution information 410 may include the recent driving-based average electricity efficiency 411 (e.g., recent average electricity efficiency: 7.4 km/kWh) and the individually monitored speed section-specific standard electricity efficiency contributions 412 for in recent driving. In addition, the first electricity efficiency contribution information 410 may include a graph 414 representing the standard contribution efficiencies for individual speed sections monitored. This allows the driver to perceive the speed sections contributing to electricity efficiency improvement or reduction, ultimately inducing driver habits for better efficiency.

Furthermore, additionally or alternatively, while the first electricity efficiency contribution information 410 is being displayed, the processor 128 may provide detailed standard efficiency contribution information for at least one speed section based on user input.

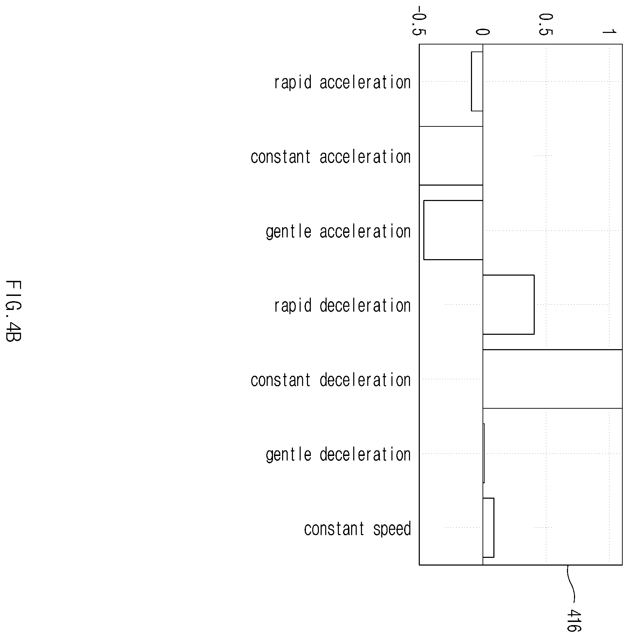

For example, when a specific speed section (e.g., low-speed section), is selected through the speed section-specific standard electricity efficiency contributions 412 or the standard electricity efficiency contribution graph 414, the processor 128, as shown in FIG. 4B, may provide speed variation section-specific standard efficiency contribution 416 for the selected speed section (e.g., rapid acceleration section, acceleration section, gentle acceleration section, rapid deceleration section, deceleration section, gentle deceleration section, or constant speed section). This allows the driver to perceive actions that decrease (e.g., acceleration action) or enhance (e.g., deceleration action) efficiency in the low-speed section.

According to an embodiment, the processor 128 may, when outputting the electricity efficiency contribution information, also provide information related to gain and loss incurred based on the standard electricity efficiency contribution. In this regard, the processor 128 may calculate gain and loss by multiplying the standard electricity efficiency contribution with unit energy cost (e.g., cost per kWh). In addition, when outputting the electricity efficiency contribution information, the processor 128 may also provide information about the proportion of sections with high or low standard electricity efficiency contributions in the overall driving range.

According to an embodiment, the processor 128 may provide a comparison result between the standard electricity efficiency contribution based on past driving and the standard electricity efficiency contribution based on current driving through the second electricity efficiency contribution information 420 related to the electricity efficiency history. In this case, the processor 128 may select one of the stored standard electricity efficiency contributions for a plurality of past drives and compare it with the standard electricity efficiency contribution for the current drive. For example, at least one of the past drives with optimal electricity efficiency, past drive immediately before the current drive, past drive on a similar route to the current drive, and past drive performed a lot over a period may be selected as a comparison target to be compared with the current drive.

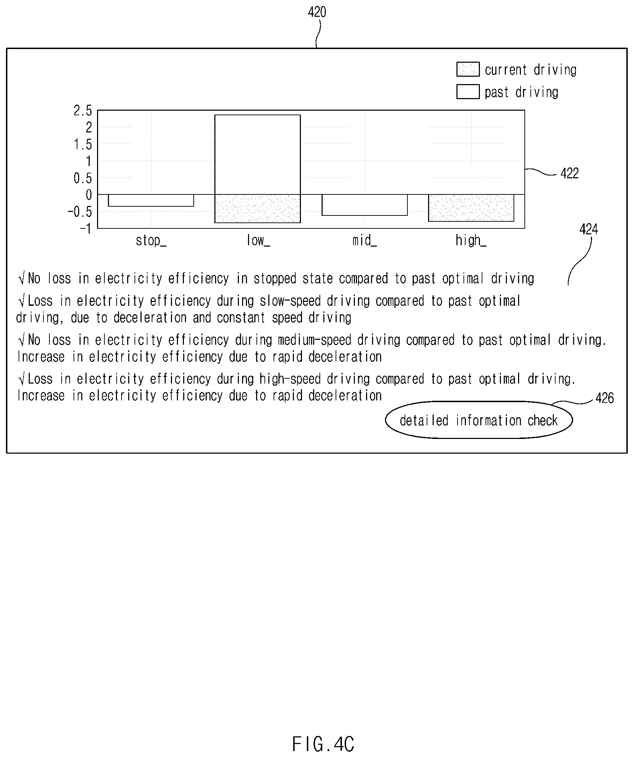

For example, as shown in FIG. 4C, the processor 128 may output the second electricity efficiency contribution information 420 including a graph 422 comparing the decrease or increase in efficiency in the current drive compared to past drives and textual information 424 regarding the comparison result.

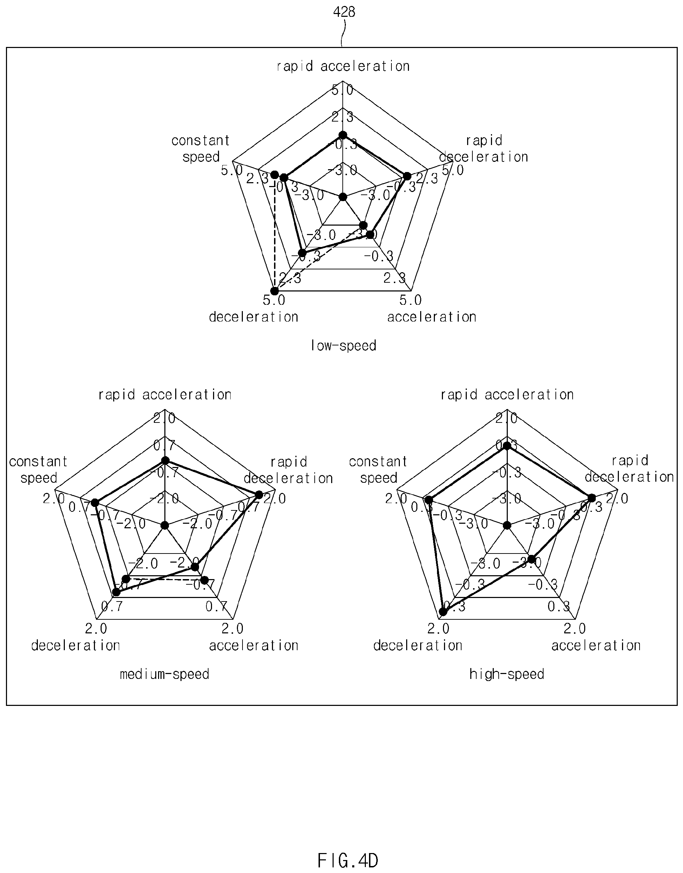

Additionally or alternatively, the second electricity efficiency contribution information 420 may include an object (e.g., a detailed information check icon 426) that triggers the output of detailed information about the sections where efficiency decreased or increased in the current drive compared to past drives. When the user's input to the object is detected, the processor 128 may provide detailed information 428 about the sections of the current drive where the electricity efficiency has decreased or increased compared to the past drive or about the speed variation sections (or actions) that have decreased or increased the electricity efficiency in those sections, as shown in FIG. 4D. Although the detailed comparison results between the electricity efficiency of past drives and the current drive were provided as detailed information 428 through a radial graph, various embodiments are not limited to this example.

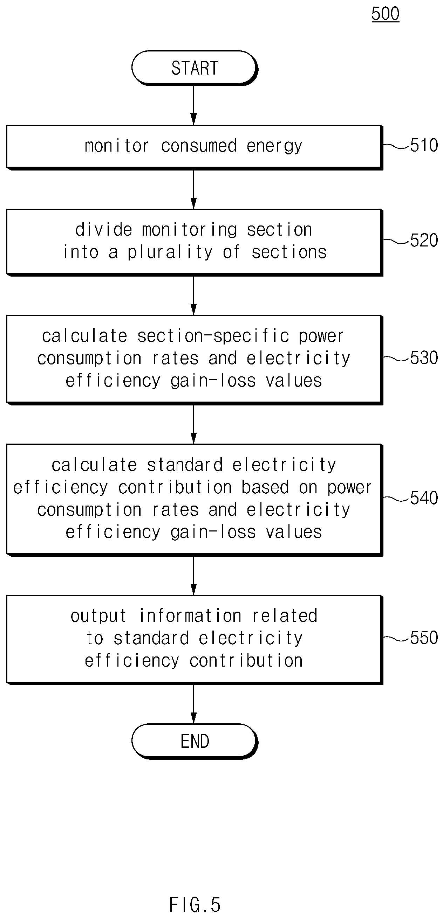

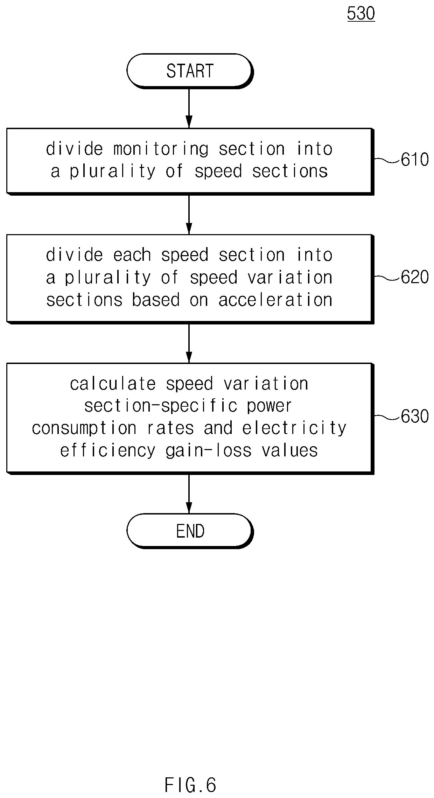

Hereinafter, a detailed description is made of the operation method of the electricity efficiency analysis device 120 according to various embodiments with reference to FIGS. 5 and 6.

FIG. 5 is a flowchart illustrating the operation of an electricity efficiency analysis device according to various embodiments. In the following embodiments, the operations may be performed in sequence, but they do not have to be carried out in a strict sequential order. For example, the order of the operations may be changed, and at least two operations may be performed in parallel. In addition, at least one of the operations may be omitted depending on the embodiment.

With reference to FIG. 5, the electricity efficiency analysis device 120 (e.g., processor 128) may monitor the energy consumption of the vehicle at operation 510. In an embodiment, the electricity efficiency analysis device 120 may monitor the energy consumption of the vehicle based on information acquired through the vehicle diagnostic device 110. For example, the electricity efficiency analysis device 120 may perform monitoring during a section (e.g., a driving section) where electrical energy is consumed by driving. In another example, the electricity efficiency analysis device 120 may also perform monitoring even in a state where driving is not actually performed (e.g., a stopped section).

In various embodiments, the electricity efficiency analysis device 120 (e.g., processor 128) may divide (or split) the monitoring section into a plurality of sections at operation 520. According to an embodiment, the electricity efficiency analysis device 120 may divide the monitoring section into a plurality of speed sections. The plurality of speed sections may include the first section (e.g., high-speed section) corresponding to the first speed range (e.g., 81 km/h and above), the second section (e.g., medium-speed section) corresponding to the second speed range (e.g., 31 km/h to 80 km/h), and the third section (e.g., low-speed section) corresponding to the third speed range (e.g., 1 km/h to 30 km/h).

According to various embodiments, the electricity efficiency analysis device 120 (e.g., processor 128), may calculate the power consumption rate and the electricity efficiency gain-loss value for each segment at operation 530. The power consumption rate may be a numerical representation of the proportion of power consumed in each segment to the total power consumption within the monitoring section, and the electricity efficiency gain-loss value may be the numerical representation of the electricity efficiency gain or loss compared to the standard electricity efficiency (e.g., certified efficiency) of the vehicle.

According to various embodiments, the power efficiency analysis device 120 (e.g., processor 128) may calculate the standard electricity efficiency contribution based on the power consumption rate and the electricity efficiency gain/loss value at operation 540. The standard electricity efficiency contribution may represent the extent to which the current electricity efficiency of the vehicle 10 affects the gain or loss (e.g., increase or decrease) compared to the standard electricity efficiency (e.g., certified efficiency). According to an embodiment, the electricity efficiency analysis device 120 may use Equation 1 to calculate the standard electricity efficiency contribution.

According to various embodiments, the electricity efficiency analysis device 120 (e.g., processor 128) may output information related to the calculated standard electricity efficiency contribution at operation 550.

According to an embodiment, the electricity efficiency analysis device 120 may output electricity efficiency contribution information including the first electricity efficiency contribution information (e.g., the first electricity efficiency contribution information 410 of FIG. 4A) related to recent efficiency and the second electricity efficiency contribution information (e.g., the second electricity efficiency contribution information 420 of FIG. 4A) related to electricity efficiency history.

According to another embodiment, the electricity efficiency analysis device 120 may also provide information related to gain-loss costs resulting from the standard electricity efficiency contribution. In this regard, the electricity efficiency analysis device 120 may calculate gain-loss costs by multiplying the standard electricity efficiency contribution with unit energy cost (e.g., cost per kWh).

According to another embodiment, the electricity efficiency analysis device 120 may also provide information about the proportion of sections with high standard electricity efficiency contributions or low standard electricity efficiency section within the entire driving section.

FIG. 6 is a flowchart illustrating the operation of calculating power consumption rate and electricity efficiency gain/loss values in an electricity efficiency analysis device according to various embodiments.

The operations described below in FIG. 6 may be various embodiments of operations 520 and 530 in FIG. 5. In the following embodiments, the operations may be performed in sequence, but they do not have to be carried out in a strict sequential order. For example, the order of the operations may be changed, and at least two operations may be performed in parallel. In addition, at least one of the operations may be omitted depending on the embodiment.

With reference to FIG. 6, the electricity efficiency analysis device 120 (or Processor 128) may differentiate a plurality of speed sections at operation 610. This corresponds to operation 520 in FIG. 5.

According to various embodiments, the electricity efficiency analysis device 120 (e.g., Processor 128), may divide each segmented speed section into a plurality of speed variation sections at operation 620. According to an embodiment, the electricity efficiency analysis device 120 may divide each speed section into a plurality of speed variation sections based on the acceleration of the vehicle 10. The plurality of speed variation sections may include at least one of a rapid acceleration section, an acceleration section, a gentle acceleration section, a rapid deceleration section, a deceleration section, a gentle deceleration section, or a constant speed section. In addition, the electricity efficiency analysis device 120 may also differentiate only certain speed variation sections satisfying a predetermined condition among the plurality of speed variation sections included in each speed section.

According to various embodiments, the electricity efficiency analysis device 120 (or Processor 128) may calculate the power consumption rate and electricity efficiency gain-loss value for each of the speed variation sections at operation 630. Afterward, the electricity efficiency analysis device 120 may calculate the standard electricity efficiency contribution for each of the speed variation sections.

The above description is merely illustrative of the technical concepts of the present invention, and various modifications and variations can be made by those skilled in the art without departing from the essential characteristics of the present invention.

Therefore, the embodiments disclosed in the present invention are not intended to limit the technical concepts of the present invention, but are provided for the purpose of explanation, and the scope of the technical idea of the present invention is not limited by these embodiments. The scope of protection of technical ideas of the present invention shall be construed by the following claims, and all technical ideas within the scope equivalent thereto shall be construed as being within the scope of the rights of the present disclosure.

**Claims**

1. An electricity efficiency analysis device comprising:

   an output device; and
   a processor electrically connected to the output device, the processor configured to:

   calculate an electricity efficiency gain-loss value indicating a gain or loss of current electricity efficiency compared to a standard electricity efficiency of a vehicle based on information collected during a predetermined monitoring section related to state and driving of the vehicle;
   calculate a standard electricity efficiency contribution indicating an extent to which the state and driving of the vehicle during the predetermined monitoring section have influenced the gain or loss of the current electricity efficiency compared to the standard electricity efficiency, based on a power consumption rate and the electricity efficiency gain-loss value during the predetermined monitoring section; and
   output the standard electricity efficiency contribution through the output device.

2. The electricity efficiency analysis device of claim 1, wherein the processor is configured to divide the predetermined monitoring section into a plurality of speed sections satisfying predetermined speed conditions based on the information and calculate speed section-specific standard electricity efficiency contributions.

3. The electricity efficiency analysis device of claim 2, wherein the processor is configured to divide each speed section into a plurality of speed variation sections satisfying predetermined speed variation conditions and calculate speed variation section-specific standard electricity efficiency contributions.

4. The electricity efficiency analysis device of claim 1, wherein the standard electricity efficiency contribution comprises at least one of a first standard electricity efficiency contribution related to a recent driving of the vehicle or a second standard electricity efficiency contribution related to a past driving history of the vehicle.

5. The electricity efficiency analysis device of claim 1, wherein the processor is configured to calculate a gain-loss cost incurred based on the standard electricity efficiency contribution and output information on the gain-loss cost through the output device.

6. The electricity efficiency analysis device of claim 1, further comprising a communication circuitry configured to establishing communication with a vehicle diagnostic device,
wherein the processor is configured to acquire the information related to the state and driving of the vehicle through the vehicle diagnostic device.

7. The electricity efficiency analysis device of claim 1, wherein the processor is configured to calculate the power consumption rate as a ratio of power consumed during the predetermined monitoring section to a total power consumption.

8. The electricity efficiency analysis device of claim 1, wherein the processor is configured to calculate the standard electricity efficiency contribution using a product of the power consumption rate and the electricity efficiency gain-loss value.

9. An electricity efficiency analysis system comprising:

a vehicle diagnostic device configured to acquire information related to state and driving of a vehicle; and
an electricity efficiency analysis device capable of communicating with the vehicle antagonistic device, the electricity efficiency analysis device configured to:

acquire an electricity efficiency gain-loss value indicating a gain or loss of current electricity efficiency of the vehicle compared to a standard electricity efficiency of the vehicle and a power consumption rate of the vehicle during a predetermined monitoring section based on the information acquired by the vehicle diagnostic device; and
calculate a standard electricity efficiency contribution indicating an extent to which the state and driving of the vehicle during the predetermined monitoring section have influenced the gain or loss of the current electricity efficiency compared to the standard electricity efficiency, based on the acquired electricity efficiency gain-loss value and the power consumption rate.

10. The electricity efficiency analysis system of claim 9, wherein the electricity efficiency analysis device is configured to acquire the electricity efficiency gain-loss value and the power consumption rate calculated by the vehicle diagnostic device.

11. The electricity efficiency analysis system of claim 9, wherein the electricity efficiency analysis device is configured to calculate the electricity efficiency gain-loss value and the power consumption rate based on the information acquired through the vehicle diagnostic device.

12. The electricity efficiency analysis system of claim 9, wherein the electricity efficiency analysis device is configured to calculate the standard electricity efficiency contribution using a product of the power consumption rate and the electricity efficiency gain-loss value.

13. An operating method of an electricity efficiency analysis device, the method comprising:

calculating an electricity efficiency gain-loss value indicating a gain or loss of current electricity efficiency compared to a standard electricity efficiency of a vehicle based on information collected during a predetermined monitoring section related to state and driving of the vehicle;
calculating a standard electricity efficiency contribution indicating an extent to which the state and driving of the vehicle during the predetermined monitoring section have influenced the gain or loss of the current electricity efficiency compared to the standard electricity efficiency, based on a power consumption rate and the electricity efficiency gain-loss value during the predetermined monitoring section; and
outputting the standard electricity efficiency contribution through an output device.

14. The operating method of claim 13, further comprising:

dividing the predetermined monitoring section into a plurality of speed sections satisfying predetermined speed conditions based on the information; and
calculating speed section-specific standard electricity efficiency contributions.

15. The operating method of claim 14, further comprising:

dividing each speed section into a plurality of speed variation sections satisfying predetermined speed variation conditions; and
calculating speed variation section-specific standard electricity efficiency contributions.

16. The operating method of claim 13, wherein the standard electricity efficiency contribution comprises at least one of a first standard electricity efficiency contribution related to a recent driving of the vehicle or a second standard electricity efficiency contribution related to a past driving history of the vehicle.

17. The operating method of claim 13, further comprising:

calculating a gain-loss cost incurred based on the standard electricity efficiency contribution; and
outputting information on the gain-loss cost through the output device.

18. The operating method of claim 13, further comprising:

establishing communication with a vehicle diagnostic device; and
acquiring the information related to the state and driving of the vehicle through the vehicle diagnostic device.

19. The operating method of claim 13, wherein the power consumption rate is calculated as a ratio of power consumed during the predetermined monitoring section to a total power consumption.

20. The operating method of claim 13, wherein the standard electricity efficiency contribution is calculated using a product of the power consumption rate and the electricity efficiency gain-loss value.

100

10

vehicle
diagnostic
device
110

electricity
efficiency
analysis device
120

FIG.1A

100

120

| communication circuitry 122 | memory 124 |
|---|---|
| output device 126 | processor 128 |

FIG.1B

FIG.2A

210

220

230

high-speed

medium-speed

low-speed

200

Speed (km/h)

Time (sec)

FIG.2B

FIG.3A

FIG.3B

410

420

recent electricity
efficiency (2022.07.01)

electricity
efficiency history

√ recent average electricity
efficiency: 7.4 km/kwh

411

- stopped section: decrease of 0.2
compared to standard electricity efficiency

- slow-speed section: increase of 0.46
compared to standard electricity efficiency

- medium-speed section: increase of 0.26
compared to standard electricity efficiency

- high-speed section: increase of 0.38
compared to standard electricity efficiency

412

400

414

| | | | |
|---|---|---|---|
| 0.5 | | | |
| 0.4 | | | |
| 0.3 | | | |
| 0.2 | | | |
| 0.1 | | | |
| 0 | | | |
| -0.1 | | | |
| -0.2 | STOP LOW MID HIGH | | |

FIG.4A

— 416

FIG.4B

420

current driving
past driving

2.5
2
1.5
1
0.5
0
-0.5
-1

stop_          low_          mid_          high_

422

424

√No loss in electricity efficiency in stopped state compared to past optimal driving

√Loss in electricity efficiency during slow-speed driving compared to past optimal driving, due to deceleration and constant speed driving

√No loss in electricity efficiency during medium-speed driving compared to past optimal driving. Increase in electricity efficiency due to rapid deceleration

√Loss in electricity efficiency during high-speed driving compared to past optimal driving. Increase in electricity efficiency due to rapid deceleration

426

detailed information check

FIG.4C

428

FIG.4D

500

```
         ┌─────────────┐
         │    START    │
         └─────────────┘
                │
                ▼
  ┌──────────────────────────────┐
  │    monitor consumed energy    │────510
  └──────────────────────────────┘
                │
                ▼
  ┌──────────────────────────────┐
  │      divide monitoring section │
  │     into a plurality of sections│────520
  └──────────────────────────────┘
                │
                ▼
  ┌──────────────────────────────┐
  │   calculate section-specific power│
  │   consumption rates and electricity│────530
  │      efficiency gain-loss values  │
  └──────────────────────────────┘
                │
                ▼
  ┌──────────────────────────────┐
  │    calculate standard electricity │
  │  efficiency contribution based on power│
  │   consumption rates and electricity│────540
  │      efficiency gain-loss values  │
  └──────────────────────────────┘
                │
                ▼
  ┌──────────────────────────────┐
  │     output information related    │
  │       to standard electricity    │────550
  │      efficiency contribution     │
  └──────────────────────────────┘
                │
                ▼
         ┌─────────────┐
         │     END     │
         └─────────────┘
```

FIG.5

<u>530</u>

```
            ┌─────────────┐
            │    START    │
            └─────────────┘
                   │
                   ▼
    ┌──────────────────────────────┐
    │  divide monitoring section into │  ～610
    │   a plurality of speed sections │
    └──────────────────────────────┘
                   │
                   ▼
    ┌──────────────────────────────┐
    │   divide each speed section into│
    │   a plurality of speed variation│  ～620
    │   sections based on acceleration│
    └──────────────────────────────┘
                   │
                   ▼
    ┌──────────────────────────────┐
    │     calculate speed variation   │
    │       section-specific power    │
    │  consumption rates and electricity│ ～630
    │    efficiency gain-loss values  │
    └──────────────────────────────┘
                   │
                   ▼
            ┌─────────────┐
            │     END     │
            └─────────────┘
```

FIG.6

## INTERNATIONAL SEARCH REPORT

| International application No. |
| --- |
| **PCT/KR2023/012004** |

### A. CLASSIFICATION OF SUBJECT MATTER

**G07C 5/02**(2006.01)i; **G01R 31/00**(2006.01)i; **G01R 22/06**(2006.01)i; **G07C 5/00**(2006.01)i; **B60L 3/12**(2006.01)i

According to International Patent Classification (IPC) or to both national classification and IPC

### B. FIELDS SEARCHED

Minimum documentation searched (classification system followed by classification symbols)

G07C 5/02(2006.01); B60K 35/00(2006.01); B60K 6/44(2007.10); B60L 11/18(2006.01); B60L 3/00(2006.01); B60L 50/50(2019.01); B60R 16/02(2006.01); G01R 31/36(2006.01); G07C 5/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 전비(electric cost), 전기차(electric vehicle), 전력 소비율(power consumption rate), 속도(velocity)

### C. DOCUMENTS CONSIDERED TO BE RELEVANT

| Category* | Citation of document, with indication, where appropriate, of the relevant passages | Relevant to claim No. |
| --- | --- | --- |
| A | US 2015-0100226 A1 (FORD GLOBAL TECHNOLOGIES, LLC) 09 April 2015 (2015-04-09)<br>See paragraphs [0035]-[0051] and figures 1 and 2b. | 1-20 |
| A | JP 2018-061364 A (MITSUBISHI MOTORS CORP) 12 April 2018 (2018-04-12)<br>See paragraphs [0022]-[0026] and figure 2. | 1-20 |
| A | US 2016-0236587 A1 (FORD GLOBAL TECHNOLOGIES, LLC) 18 August 2016 (2016-08-18)<br>See paragraphs [0044]-[0049] and figures 2-4. | 1-20 |
| A | KR 10-2017-0034593 A (HYUNDAI MOTOR COMPANY) 29 March 2017 (2017-03-29)<br>See paragraphs [0023]-[0036] and figures 1-3. | 1-20 |
| A | KR 10-1956384 B1 (HYUNDAI MOTOR COMPANY) 08 March 2019 (2019-03-08)<br>See claims 1-3. | 1-20 |

☐ Further documents are listed in the continuation of Box C.　　☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **15 November 2023** | **15 November 2023** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2023/012004**

| Patent document cited in search report | | | Publication date (day/month/year) | Patent family member(s) | | | Publication date (day/month/year) |
|---|---|---|---|---|---|---|---|
| US | 2015-0100226 | A1 | 09 April 2015 | CN | 104512272 | A | 15 April 2015 |
| | | | | CN | 104512272 | B | 10 July 2018 |
| | | | | DE | 102014219661 | A1 | 09 April 2015 |
| | | | | US | 9292976 | B2 | 22 March 2016 |
| JP | 2018-061364 | A | 12 April 2018 | CN | 107918309 | A | 17 April 2018 |
| | | | | EP | 3305583 | A1 | 11 April 2018 |
| | | | | JP | 6738045 | B2 | 12 August 2020 |
| | | | | US | 10600262 | B2 | 24 March 2020 |
| | | | | US | 2018-0102002 | A1 | 12 April 2018 |
| US | 2016-0236587 | A1 | 18 August 2016 | CN | 104859660 | A | 26 August 2015 |
| | | | | CN | 104859660 | B | 14 May 2019 |
| | | | | DE | 102015202845 | A1 | 27 August 2015 |
| | | | | DE | 102015202845 | A8 | 10 March 2022 |
| | | | | US | 10059219 | B2 | 28 August 2018 |
| | | | | US | 2015-0239455 | A1 | 27 August 2015 |
| | | | | US | 9346452 | B2 | 24 May 2016 |
| KR | 10-2017-0034593 | A | 29 March 2017 | CN | 106541841 | A | 29 March 2017 |
| | | | | CN | 106541841 | B | 10 August 2021 |
| | | | | US | 2017-0080806 | A1 | 23 March 2017 |
| | | | | US | 9694687 | B2 | 04 July 2017 |
| KR | 10-1956384 | B1 | 08 March 2019 | CN | 103419787 | A | 04 December 2013 |
| | | | | CN | 103419787 | B | 02 October 2018 |
| | | | | DE | 102012214962 | A1 | 21 November 2013 |
| | | | | DE | 102012214962 | B4 | 17 March 2022 |
| | | | | JP | 2013-243899 | A | 05 December 2013 |
| | | | | JP | 6009271 | B2 | 19 October 2016 |
| | | | | US | 2013-0311016 | A1 | 21 November 2013 |
| | | | | US | 9037327 | B2 | 19 May 2015 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020220101645

- KR 1020230105701